# EUROPEAN PATENT APPLICATION

(11) **EP 4 190 946 A1**
(43) Date of publication of application: **07.06.2023**
(21) Application number: 20962257.0
(22) Date of filing: 14.12.2020
(51) Int. Cl.: C30B 23/02

(54) **CRUCIBLE MOVABLE BEAM SOURCE FURNACE FOR MOLECULAR-BEAM EPITAXY**

(30) Priority: 20.11.2020 CN 202011315020
(71) Applicant: Hunan Semicorepi Semiconductor Technology Co., Ltd., Changsha, Hunan 410000 (CN)
(72) Inventor: DU, Peng, Changsha, Hunan 410000 (CN); GONG, Xin, Changsha, Hunan 410000 (CN); FU, Hongwei, Changsha, Hunan 410000 (CN); WEI, Wei, Changsha, Hunan 410000 (CN); CHEN, Fengwu, Changsha, Hunan 410000 (CN); XIAO, Hui, Changsha, Hunan 410000 (CN); NING, Shu, Changsha, Hunan 410000 (CN); LV, Wenli, Changsha, Hunan 410000 (CN)
(74) Representative: Herrmann, Uwe
(86) International application number: PCT/CN2020/136111
(87) International publication number: WO 2022/104966

(57) **Abstract**

The invention discloses an effusion cell with a movable crucible for molecular beam epitaxy, comprising a crucible bracket (5), a mounting flange (1), a heat shielding cylinder (2) arranged on an upper side of the mounting flange (1), a gate valve (3) arranged on a lower side of the mounting flange (1), an outer cylinder (4) arranged on a lower side of the gate valve (3) and a lift driving device (6) for driving the crucible bracket (5) to move between the heat shielding cylinder (2) and the outer cylinder (4), the heat shielding cylinder (2) is internally provided with a heater (21), the outer cylinder (4) is connected to a vacuum pump, and the lift driving device (6) is hermetically connected to the outer cylinder (4). The invention has the advantages of simple structure, low cost, high reliability, compact space, and the like.

## Description

### Technical Field

The invention relates to semiconductor devices, and particularly relates to an effusion cell with a movable crucible for molecular beam epitaxy.

### Description of Related Art

Molecular beam epitaxy (MBE) is a method for preparing single crystal film by injecting atoms or molecules that forming components or doping of the crystal at a certain thermal kinematic velocity and at a certain proportion of components from an effusion cell to the surface of a substrate for epitaxial growth in an ultrahigh vacuum environment. The effusion cell is an important component of an MBE equipment and obtains a stable and controllable evaporation beam flow by heating a source material in its crucible.

According to the movable effusion cell, in the premise of not venting an entire growth chamber, the effusion cell is extracted and isolated from the ultrahigh vacuum environment by means of a gate valve. After maintenance of the effusion cell or refilling of the source material, the effusion cell is then fed back to the growth chamber. In the whole process, the growth chamber is kept in an ultrahigh vacuum state all the time, so that a pumping and baking time for several weeks are saved. On the other hand, during maintenance of the growth chamber, the effusion cell can be also extracted and isolated, so that in venting process of the chamber, the effusion cell is not exposed to the atmosphere, and therefore, the source material in the effusion cell is effectively prevented from being oxidized and polluted.

An existing movable effusion cell usually switches between a working position and a maintenance position by means of a bellows and a guidance and translation system, and in a case where the effusion cell is switched to the working position, the bellows is compressed. In a case where the effusion cell is switched by guidance and translation system to the maintenance position, the bellows is stretched. However, to move the effusion cell as a whole, the distance is long, which puts a strict request on alignment of the guidance and translation system. The effusion cell moves as a whole, which results in a considerable diameter and space of the bellows. Thus, the bellows is high in cost, and needs to bear a huge pressure difference between an internal vacuum environment and an external atmospheric environment during movement, which is a great challenge to reliability of the bellows. Meanwhile, the effusion cell is usually mounted obliquely upward, and material debris (for example, flakes or particles) in the growth chamber may fall into the bellows, which may result in damage of the bellows.

For this purpose, a movable effusion cell without bellows is provided in the prior art. The effusion cell moves as a whole in a fixed cylinder, so that the space and cost are saved. However, the technical solution has defects that during movement of the effusion cell, the power and thermocouple cables move therewith, and therefore it is needed to design a complicated cable management device; and the lifetime of the cables will be affected by tension change in repeated winding and stretching processes of the cables, so that the reliability of the entire design is reduced.

### SUMMARY

To overcome defects in the prior art, the invention provides an effusion cell with a movable crucible for molecular beam epitaxy, featuring simple structure, low cost, high reliability and compact space.

To settle the aforesaid technical issue, the invention adopts the following technical solution:
An effusion cell with a movable crucible for molecular beam epitaxy, comprising a crucible bracket, a mounting flange, a heat shielding cylinder arranged on an upper side of the mounting flange, a gate valve arranged on a lower side of the mounting flange, an outer cylinder arranged on a lower side of the gate valve and a lift driving device for driving the crucible bracket to move between the heat shielding cylinder and the outer cylinder, wherein the heat shielding cylinder is internally provided with a heater, the outer cylinder is connected to a vacuum pump, and the lift driving device is hermetically attached to the outer cylinder.

As a further improvement of the above technical proposal: a water cooling shroud is arranged on an inner side of the heat shielding cylinder, a heat shield is arranged on an inner side of the water cooling shroud, and the heater is arranged on an inner side of the heat shield.

As a further improvement of the above technical proposal: wherein a cooling water inlet/outlet and power feedthrough are arranged on a side wall of the mounting flange, the water cooling shroud is communicated with a water cooling system by means of the cooling water inlet/outlet, and the heater is communicated with a power supply by means of the power feedthrough.

As a further improvement of the above technical proposal: wherein a connecting cylinder is further arranged between the mounting flange and the gate valve, the cooling water inlet/outlet is arranged on the side wall of the mounting flange, the power feedthrough is arranged on a side wall of the connecting cylinder, the water cooling shroud is communicated with the cooling water source by means of the cooling water inlet/outlet, and the heater is communicated with the power supply by means of the power feedthrough.

As a further improvement of the above technical proposal: wherein the heat shielding cylinder is internally provided with a fixed thermocouple, a fixed thermocouple feedthrough is arranged on the side wall of the connecting cylinder, and the fixed thermocouple is communicated with a temperature controller by means of the fixed thermocouple feedthrough.

As a further improvement of the above technical proposal: wherein the heat shielding cylinder is internally provided with the fixed thermocouple, the fixed thermocouple feedthrough is arranged on the side wall of the mounting flange, and the fixed thermocouple is communicated with the temperature controller by means of the fixed thermocouple feedthrough.

As a further improvement of the above technical proposal: wherein the lift driving device is a magnetically coupled motion transmitting mechanism.

As a further improvement of the above technical proposal: wherein the crucible bracket is provided with a movable thermocouple, and a working end of the movable thermocouple contacts the crucible.

As a further improvement of the above technical proposal: wherein the crucible bracket is provided with a movable thermocouple feedthrough, and the movable thermocouple is communicated with the temperature controller by means of the movable thermocouple feedthrough.

As a further improvement of the above technical proposal: wherein the lift driving device comprises a driving guide and a bellows, an upper end of the bellows is hermetically connected to the bottom of the outer cylinder, and a lower end of the bellows is hermetically connected to the bottom of the crucible bracket.

Compared with the prior art of which the effusion cell moves as a whole, the present invention offers distinct advantages. Only the crucible and the crucible bracket are moved by the lift driving device to extend and retract by means of the mounting flange and the gate valve, so that the working position and the maintenance position are switched. In the entire process, the ultrahigh vacuum of the growth chamber is not broken, the downtime is shortened and the process efficiency is improved; when the crucible and the crucible bracket move, other parts such as the heater are still fixed in the heat shielding cylinder, so that design of a long-distance and heavy-caliber bellows or a complicated cable management device is avoided, the space is saved, the cost is lowered, and meanwhile, the reliability of the movable effusion cell is improved.

### BRIEF DESCRIPTION OF THE DRAWINGS

FIG. 1 is a schematic structural diagram of an effusion cell with a movable crucible for molecular beam epitaxy in an embodiment 1 of the invention in a working position.
FIG. 2 is a schematic structural diagram of a heat shielding cylinder in the invention.
FIG. 3 is a schematic structural diagram of an effusion cell with a movable crucible for molecular beam epitaxy in an embodiment 1 of the invention retracted from the working position to a maintenance position.
FIG. 4 is a schematic structural diagram of an effusion cell with a movable crucible for molecular beam epitaxy in an embodiment 2 of the invention in a working position.
FIG. 5 is a schematic structural diagram of an effusion cell with a movable crucible for molecular beam epitaxy in an embodiment 3 of the invention in a working position.
FIG. 6 is a schematic structural diagram of an effusion cell with a movable crucible for molecular beam epitaxy in an embodiment 3 of the invention retracted from the working position to a maintenance position.

Numerals in the drawings: 1-mounting flange; 11-cooling water inlet/outlet; 12-power feedthrough; 13-fixed thermocouple feedthrough; 2-heat shielding cylinder; 21-heater; 22-fixed thermocouple; 23-water cooling shroud; 24-heat shield; 25-supporting rod; 3-gate valve; 4-outer cylinder; 41-vacuum pump connector; 5-crucible bracket; 51-movable thermocouple; 52-movable thermocouple feedthrough; 6-lift driving device; 61-driving guide; 62-bellows; 7-connecting cylinder; 8-crucible.

### DESCRIPTION OF THE EMBODIMENTS

The invention will be further described in detail below in combination with drawings and specific embodiments.

### Embodiment 1

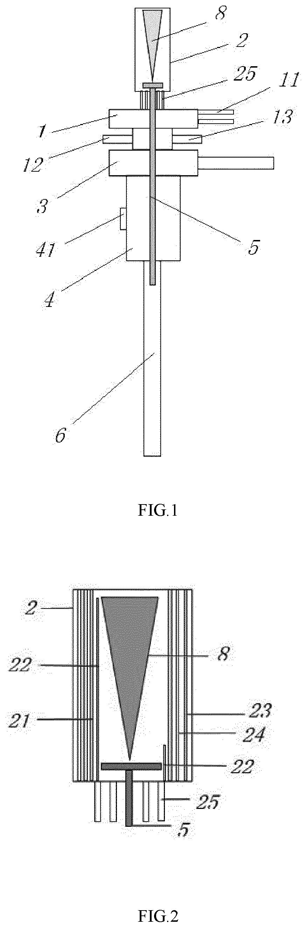

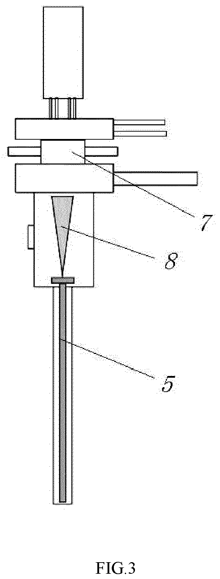

FIG. 1 to FIG. 3 show an embodiment of an effusion cell with a movable crucible for molecular beam epitaxy. The effusion cell with a movable crucible for molecular beam epitaxy in the embodiment includes a heat shielding cylinder 2, a supporting rod 25 (used for providing support for the heat shielding cylinder 2, and of course, in other embodiments, other parts can also be used for providing support for the heat shielding cylinder 2), a crucible 8, a crucible bracket 5, a mounting flange 1, a gate valve 3, a fixed thermocouple 22, a heater 21, a heat shield 24, a water cooling shroud 23, a connecting cylinder 7, a power feedthrough 12, a fixed thermocouple feedthrough 13, an outer cylinder 4, a vacuum pump connector 41 and a magnetically coupled driving device.

The effusion cell is connected to a growth chamber by means of the mounting flange 1, the mounting flange 1 is opened in the middle, and the crucible 8 and the crucible bracket 5 can move up and down through the middle opening of the mounting flange 1.

A part of the effusion cell located in the growth chamber is shown in FIG. 2, the heat shielding cylinder 2 is fixed to the mounting flange 1 by means of the supporting rod 25, and the heat shielding cylinder 2 provides support and protection for an internal structure thereof. The heat shielding cylinder 2 is internally provided with the water cooling shroud 23, the heat shield 24, the heater 21 and the fixed thermocouple 22 successively from edge to center, and the parts can be fixed and isolated by means of insulating support (not shown in the drawings). The water cooling shroud 23 can be either an integrated water cooling or a discrete water cooling for preventing the effusion cell itself and other parts in the MBE device from being affected by high temperature. The heat shield 24 can be made of single-layer or multi-layer refractory metal, including, but not limited to, tantalum, molybdenum, tungsten and the like. The heat shield 24 is used for reflecting heat radiation of the heater 21, so as to improve the internal heating efficiency and reduce the external heat dissipation. The heater 21 forms an evaporation beam flow by heating source material in the crucible 8, and the heater can be made of a pyrolytic boron nitride/ pyrolytic graphite/ pyrolytic boron nitride (PBN/PG/PBN) composite material or other refractory metal, including, but not limited to tantalum, molybdenum, tungsten and the like. The fixed thermocouple 22 is close to the crucible 8 without hindering movement of the crucible 8 and the crucible bracket 5. There can be one or more fixed thermocouples 22 for measuring temperatures corresponding to different positions of the crucible 8. Two fixed thermocouples 22 are used in the embodiment to measure the temperatures corresponding to the top and bottom areas of the crucible 8 respectively.

The lower end of the heat shielding cylinder 2 is opened, so that the crucible 8 and the crucible bracket 5 are extracted from the opening in the lower end of the heat shielding cylinder 2. The upper end of the heat shielding cylinder 2 is opened, so that the evaporation beam flow is ejected by means of the opening in the end of the heat shielding cylinder 2. The crucible 8 can be made of the PBN material, and an insert (not shown in the drawings) can be added to the crucible 8 to guide and improve the shape of the evaporation beam flow. The insert can be made of the PBN material. The crucible bracket 5 consists of multiple parts. A topmost crucible receptacle can be made of insulating material such as PBN or other ceramic. High-temperature area at the upper end of the crucible bracket 5 can be made of refractory material such as tantalum, molybdenum or tungsten. Non-high-temperature area at the lower end of the crucible bracket 5 can be made of stainless steel material.

The connecting cylinder 7 is connected to the mounting flange 1 and the gate valve 3, the connecting cylinder 7 is hollow, and the crucible 8 and the crucible bracket 5 can move through by means of the connecting cylinder 7. The power feedthrough 12, the fixed thermocouple feedthrough 13 and the cooling water inlet/outlet 11 are connected out from the mounting flange 1 or the connecting cylinder 7. The heater 21 is connected to the power feedthrough 12 by means of power cables (not shown in the drawings) and is then connected to an external power supply, and the fixed thermocouple 22 is connected to the fixed thermocouple feedthrough 13 by means of thermocouple cables (not shown in the drawings) and is then connected to an external temperature controller. Since the heater 21 and the fixed thermocouple 22 do not move along with the crucible 8 and the crucible bracket 5, the power cables and the thermocouple cables need not stretch, so that it is unnecessary to design complicated cable winding device. Thus, the reliability of a system is further improved.

The outer cylinder 4 is provided with a vacuum pump connector 41 and is externally connected to a vacuum pump by means of the vacuum pump connector 41 for independent pumping and venting of the outer cylinder 4. A lift driving device 6 is mounted at the bottom of the outer cylinder 4, and the lift driving device 6 is a magnetically coupled motion transmitting mechanism which drives the crucible bracket 5 and the crucible 8 disposed thereon to move in manual or electric mode and has precise positioning and position indicating functions.

The outer cylinder 4 can be isolated from the growth chamber by means of the gate valve 3. In a case where the crucible 8 and the crucible bracket 5 extend upwards and are located in the working position, the gate valve is switched on, and the growth chamber and the outer cylinder 4 share the same vacuum environment; in a case where the crucible 8 and the crucible bracket 5 retract downwards and are located in the maintenance position, the gate valve is switched off for independent pumping and venting operations of the outer cylinder 4. A refilling operation process for the source material is as follows: the crucible 8 and the crucible bracket 5 retract to the maintenance position; the gate valve is switched off; the outer cylinder 4 is vented to atmosphere pressure; the outer cylinder 4 is detached from the gate valve; the crucible 8 is taken out from the crucible bracket 5; filling of the source material is performed; the crucible 8 is placed back on the crucible bracket 5; the outer cylinder 4 is connected to the gate valve; the outer cylinder 4 is pumped to a certain vacuum state; the gate valve is switched on; and the crucible 8 and the crucible bracket 5 extend out to the working position.

### Embodiment 2

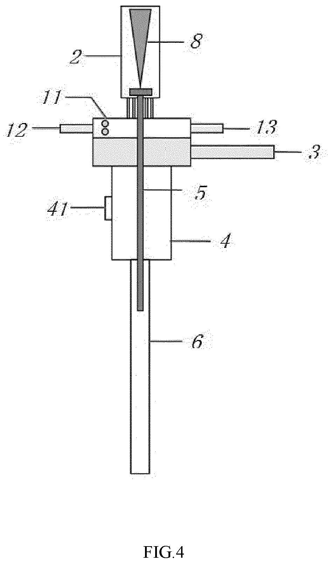

FIG. 4 shows another embodiment of the effusion cell with a movable crucible for molecular beam epitaxy provided by the invention. The embodiment is substantially the same with the embodiment 1 in structure and principle. The difference lies in that no extra connecting cylinder 7 is designed in the embodiment, the mounting flange 1 is directly connected to the gate valve 3, and the power feedthrough 12, the fixed thermocouple feedthrough 13 and the cooling water inlet/outlet 11 are connected out from a lateral side of the mounting flange 1, so that the structure is more compact. Based on the embodiment 1, the moving distance of the crucible 8 and the crucible bracket 5 are further shortened, so that the space is saved and the cost is lowered.

### Embodiment 3

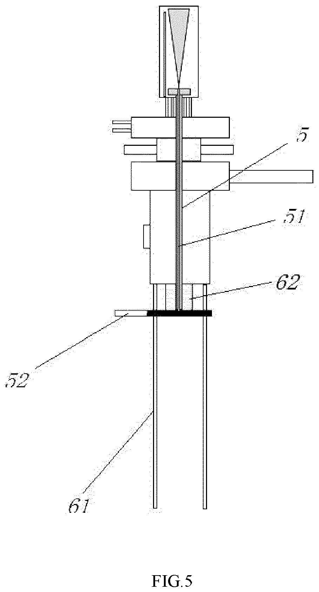

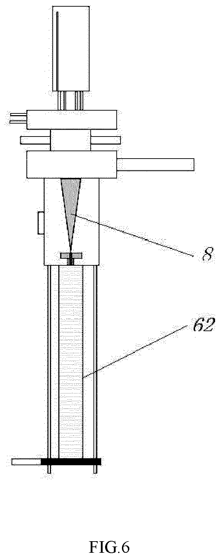

FIG. 5 to FIG. 6 show another embodiment of the effusion cell with a movable crucible for molecular beam epitaxy provided by the invention. In order to directly measure the temperature of the bottom of the crucible 8 by the thermocouple, the embodiment provides an effusion cell with a movable crucible, including a driving guide 61 and a bellows 62. There are two types of thermocouples in the embodiment: the fixed thermocouple 22 and the movable thermocouple 51. The fixed thermocouple 22 is fixed in the heat shielding cylinder 2 and does not move along with the crucible 8 and the crucible bracket 5. There can be one or more fixed thermocouples 22 for measuring temperatures corresponding to different positions of the crucible 8 in a non-contact manner, which is the same with the embodiment 1. There is usually one movable thermocouple 51. A working end of the movable thermocouple 51 passes through the top of the crucible bracket 5 and directly contacts the bottom of the crucible 8, so that the actual temperature of the bottom of the crucible 8 can be measured more accurately. The movable thermocouple 51 is connected to the external temperature controller by means of the movable thermocouple feedthrough 52 settled at the bottom of the crucible bracket 5.

The movable thermocouple 51 is involved in movement of the thermocouple cables, so that the problem is solved by mean of the driving guide 61 and the bellows 62. In a case where the crucible bracket 5 and the crucible 8 disposed thereon are driven by the driving guide 61 to extend upwards, the bellows 62 is compressed. In a case where the crucible bracket 5 and the crucible 8 disposed thereon are driven by the driving guide 61 to retract downwards, the bellows 62 is stretched.

Different from the existing movable effusion cell including bellows and the driving guide rail, in the embodiment, since only the crucible 8 and the crucible bracket 5 move, the device is shorter in distance compared with moving the effusion cell as a whole, and the caliber required by the bellows 62 is smaller, so that the risk that material debris falls into the bellows 62 to damage the bellows 62 is reduced. Therefore, the system is lower in cost and higher in reliability.

Although the invention has been disclosed with the preferred embodiments, the preferred embodiments are not used to limit the invention. Those skilled in the art can make various possible alternations and modification on the technical solution of the invention or modify the technical solution of the invention as equivalently changed equivalent embodiments by means of the above disclosed technical content without departing from the scope of the technical solution of the invention. Therefore, any subtle modifications, equivalent changes and modifications made on the embodiments in accordance with the technical essence of the invention shall fall within the scope of the technical solution of the invention without departing from the content of the technical solution of the invention.

## Claims

1. An effusion cell with a movable crucible for molecular beam epitaxy, **characterized in that** comprising a crucible bracket (5), a mounting flange (1), a heat shielding cylinder (2) arranged on an upper side of the mounting flange (1), a gate valve (3) arranged on a lower side of the mounting flange (1), an outer cylinder (4) arranged on a lower side of the gate valve (3) and a lift driving device (6) for driving the crucible bracket (5) to move between the heat shielding cylinder (2) and the outer cylinder (4), the heat shielding cylinder (2) is internally provided with a heater (21), the outer cylinder (4) is connected to a vacuum pump, and the lift driving device (6) is hermetically connected to the outer cylinder (4).

2. The effusion cell with a movable crucible for molecular beam epitaxy according to claim 1, **characterized in that** a water cooling shroud (23) is arranged on an inner side of the heat shielding cylinder (2), a heat shield (24) is arranged on an inner side of the water cooling shroud (23), and the heater (21) is arranged on an inner side of the heat shield (24).

3. The effusion cell with a movable crucible for molecular beam epitaxy according to claim 2, **characterized in that** a cooling water inlet/outlet (11) and a power feedthrough (12) are arranged on a side wall of the mounting flange (1), the water cooling shroud (23) is communicated with a cooling water source by means of the cooling water inlet/outlet (11), and the heater (21) is communicated with a power supply by means of the power feedthrough (12).

4. The effusion cell with a movable crucible for molecular beam epitaxy according to claim 2, **characterized in that** a connecting cylinder (7) is further arranged between the mounting flange (1) and the gate valve (3), a cooling water inlet/outlet (11) is arranged on a side wall of the mounting flange (1), a power feedthrough (12) is arranged on a side wall of the connecting cylinder (7), the water cooling shroud (23) is communicated with a cooling water source by means of the cooling water inlet/outlet (11), and the heater (21) is communicated with a power supply by means of the power feedthrough (12).

5. The effusion cell with a movable crucible for molecular beam epitaxy according to claim 4, **characterized in that** the heat shielding cylinder (2) is internally provided with a fixed thermocouple (22), a fixed thermocouple feedthrough (13) is arranged on the side wall of the connecting cylinder (7), and the fixed thermocouple (22) is communicated with a temperature controller by means of the fixed thermocouple feedthrough (13).

6. The effusion cell with a movable crucible for molecular beam epitaxy according to claim 3, **characterized in that** the heat shielding cylinder (2) is internally provided with a fixed thermocouple (22), a fixed thermocouple feedthrough (13) is arranged on the side wall of the mounting flange (1), and the fixed thermocouple (22) is communicated with the temperature controller by means of the fixed thermocouple feedthrough (13).

7. The effusion cell with a movable crucible for molecular beam epitaxy according to any one of claims 1-6, **characterized in that** the lift driving device (6) is a magnetically coupled motion transmitting mechanism.

8. The effusion cell with a movable crucible for molecular beam epitaxy according to any one of claims 1-6, **characterized in that** the crucible bracket (5) is provided with a movable thermocouple (51), and a working end of the movable thermocouple (51) contacts the crucible (8).

9. The effusion cell with a movable crucible for molecular beam epitaxy according to claim 8, **characterized in that** the crucible bracket (5) is provided with a movable thermocouple feedthrough (52), and the movable thermocouple (51) is communicated with a temperature controller by means of the movable thermocouple feedthrough (52).

10. The effusion cell with a movable crucible for molecular beam epitaxy according to claim 8, **characterized in that** the lift driving device (6) comprises a driving guide (61) and a bellows (62), an upper end of the bellows (62) is hermetically connected to a bottom of the outer cylinder (4), and a lower end of the bellows (62) is hermetically connected to a bottom of the crucible bracket (5).
